# EUROPÄISCHE PATENTSCHRIFT

(11) **EP 2 746 355 B1**
(45) Veröffentlichungstag und Bekanntmachung des Hinweises auf die Patenterteilung: **29.08.2018**
(21) Anmeldenummer: 13197824.9
(22) Anmeldetag: 17.12.2013
(51) Int. Cl.: C09J 5/02, C08J 7/12, A47B 95/04, C23C 16/453, C23C 16/40

(54) **Verfahren zum Befestigen einer Kunststoffleiste**
Process for attaching a plastic strip
Procédé de fixation d'une bande en matière synthétique

(30) Priorität: 19.12.2012 DE 102012112607
(43) Veröffentlichungstag der Anmeldung: 25.06.2014
(73) Patentinhaber: Döllken-Kunststoffverarbeitung GmbH, 45964 Gladbeck (DE)
(72) Erfinder:
(74) Vertreter: von dem Borne, Andreas

(56) Entgegenhaltungen:
- DE-A1- 19 905 697
- DE-A1-102006 045 951
- DE-A1-102007 004 229

## Beschreibung

Die Erfindung betrifft eine Kunststoffleiste, insbesondere eine Kantenleiste für eine Schmalflächenbeschichtung eines plattenförmigen Werkstücks, wie z. B. einer Möbelplatte, mit einer zu verklebenden Fügefläche. Solche Kantenleisten bzw. Deckleisten werden auch einfach als Kanten oder Kantenbänder bzw. Umleimer bezeichnet. Bei den plattenförmigen Werkstücken bzw. Möbelplatten kann es sich insbesondere um Holzwerkstoffplatten, z. B. Spanplatten, Faserplatten oder dergleichen handeln. Es werden aber auch Platten und andere Werkstücke aus anderen Werkstoffen umfasst. Bei der Kunststoffleiste kann es sich folglich auch um ein Profil aus Kunststoff handeln, welches an einem Werkstück zu befestigen ist.

Es ist grundsätzlich bekannt, Kantenleisten bzw. Kantenbänder, die auch als Umleimer bezeichnet werden, mittels Schmelzklebstoffen maschinell an den Schmalflächen von Möbelplatten zu befestigen. Die Kantenbänder können aus papier- oder polymerbasierenden Werkstoffen bestehen. So sind insbesondere Kantenbänder oder ähnliche Profile aus Kunststoff bekannt. Als Schmelzklebstoffe werden z. B. Polymersysteme auf EVA-, APAO-, PA-, TPU-(E)- oder PUR-Basis verwendet. Die erzielten Haftungsfestigkeiten solcher Schmelzklebstoffe auf thermoplastischen Kunststoffen sind in der Regel gering bzw. nicht beständig gegen Beanspruchung und Alterung. Aus diesem Grunde ist es in der Praxis üblich, die zu verklebende Fügefläche (in der Regel die Kantenbandrückseite) mit einem Haftvermittler zu versehen. Dabei ist zu berücksichtigen, dass der eingesetzte Haftvermittlertyp mit den später einzusetzenden Schmelzklebstoffen sowie dem Kantenbandpolymer harmoniert. Die üblicherweise eingesetzten Haftvermittler sind in der Regel lösemittelhaltige oder wässrige Systeme, die neben variablen Anteilen an gelösten bzw. dispergierten Bindemitteln Füllstoffe in unterschiedlichen Mengen und Korngrößen enthalten. Die Anbindung zum Kantenbandpolymer erfolgt aus der Wechselwirkung von Lösemitteleinfluss der Kantenbandoberfläche und der Adhäsionsneigung des eingesetzten Bindemittels. Der eingesetzte Füllstoff hat die Aufgabe die zur Anbindung des Schmelzklebstoffs vorhandene Oberfläche zu erhöhen. Neben dem klassischen Haftvermittlersystem auf Lösungsmittelbasis werden auch Haftvermittlerdispersionen auf wässriger Basis eingesetzt. Hierbei handelt es sich um wässrige Dispersionen von Bindemitteln, die ebenfalls Füllstoffe wie Kieselsäure oder Kreide sowie geringen Mengen von organischen Additiven zur Haftungsverbesserung enthalten können.

Der Einsatz von Haftvermittlern ist zwar seit langem bekannt und in der Praxis üblich, er ist jedoch mit einem verhältnismäßig hohen Aufwand bei der Anwendung verbunden. Neben der erforderlichen systemabhängigen Auftragstechnik kommen hohe Energiekosten zur Trocknung (zumindest bei wässrigen Systemen) bzw. ein hoher Aufwand bei der Einhaltung vom Umweltauflagen, z. B. Lösemittelbeseitigung hinzu. Insgesamt ist der Einsatz von Haftvermittlern mit verhältnismäßig hohen Kosten verbunden. Ferner können Abweichungen bei der Haftvermittlerbeschichtung gegebenenfalls zu Fehlverklebungen führen.

Bei unpolaren Polymeren, wie z. B. PP oder PE, ist es vor dem Auftragen des Haftvermittlers außerdem häufig eine Vorbehandlung (Aktivierung) der Kantenbandrückseite mittels physikalischer oder chemischer Verfahren erforderlich. Nach entsprechender Vorbehandlung erfolgt dann die Beschichtung mit einem Haftvermittler, so dass später die gewünschte Verklebung mit einem Schmelzklebstoff möglich ist. Der Aufwand der bekannten Herstellungs- und Verarbeitungsverfahren ist folglich insgesamt hoch. - Hier setzt die Erfindung ein.

Der Erfindung liegt die Aufgabe zugrunde, eine Kunststoffleiste, insbesondere eine Kantenleiste für eine Schmalflächenbeschichtung eines plattenförmigen Werkstücks, wie z. B. einer Möbelplatte, zu schaffen, die sich durch einfache und kostengünstige Herstellung und Verarbeitung auszeichnet.

Zur Lösung dieser Aufgabe lehrt die Erfindung bei einer gattungsgemäßen Kunststoffleiste, z. B. einer Kantenleiste, dass die zu verklebende haftvermittlerfreie Fügefläche mittels Flammsilikatisierung unter Bildung einer SiO₂-Beschichtung vorbehandelt und haftvermittlerfrei ausgebildet ist.

Die Erfindung geht dabei von der überraschenden Erkenntnis aus, dass sich eine Kunststoffleiste, z. B. ein Kantenband, ohne den Einsatz von Haftvermittlern einwandfrei mit Hilfe eines Schmelzklebstoffs verkleben lässt, wenn die zu verklebende Fügefläche, insbesondere die Leistenrückseite, im Wege einer Flammsilikatisierung vorbehandelt wird. Bei der Flammsilikatisierung wird die Fügefläche mit einer Flamme beaufschlagt, indem ein Brenngas verbrannt wird, wobei dem Brenngas ein oder mehrere Silane bzw. Silanverbindungen zugesetzt werden. Durch die Flamme erfolgt zum einen eine Vorbehandlung im Sinne einer Aktivierung der Kunststoff-Oberfläche durch Oxidation der Oberfläche und der damit verbundenen Erzeugung von reaktiven Gruppen bzw. der Einbindung von Sauerstoff an der Oberfläche des Polymers. Dieser Prozess wird in der Regel im oxidativen Bereich des Flammkegels erreicht und führt zur Erhöhung der Oberflächenspannung und Polarität. Außerdem werden der Flamme Silane oder Silanverbindungen zugegeben, so dass eine Beschichtung der durch die Flamme aktivierten Kunststoffoberfläche mit polymerem amorphen SiO₂-n-Strukturen durch Oxidation der Silane in der Flamme erfolgt, wobei eine Anhaftung der SiO₂- bzw. SiO₂-n-Strukturen mit der Polymeroberfläche erzeugt wird. Überraschenderweise lassen sich die auf diese Weise behandelten Kunststoffleisten einwandfrei mit herkömmlichen Schmelzklebstoffen verkleben, ohne dass Haftvermittler eingesetzt werden müssen. Die erfindungsgemäß hergestellte Kunststoffleiste lässt sich folglich einfach und kostengünstig herstellen und insbesondere einfach und kostengünstig verarbeiten, ohne dass Nachteile bei der Verklebung in Kauf genommen werden müssen.

Die Flammsilikatisierung (die auch Flammpyrolyse genannt wird) ist ein grundsätzlich bekanntes Verfahren zur Siliziumdioxidbeschichtung von Glas, Aluminium, Stahlband und auch Kunststoff mit einer amorphen Silikatschicht im Bereich von deutlich weniger als 1 µm. In der Praxis erfolgt eine solche Behandlung in der Regel zum Korrosionsschutz von metallischen Oberflächen, zum Schutz von Glasoberflächen bzw. zur Erzeugung von optisch aktiven Beschichtungen oder schmutzabweichenden Oberflächenmodizierungen. In der Regel sollen also stark hydrophobe Siliziumdioxidbeschichtungen zum Oberflächenschutz erzielt werden.

Derartige Verfahren zur Erzeugung von Haftschichten auf Oberflächen werden z. B. in der DE 199 05 697 A1 beschrieben. In der Praxis ist es aber üblich, zunächst in einem ersten Schritt eine silikatische Schicht auf die Oberfläche aufzubringen (Silikatisierung) und in einem zweiten Schritt die silikatisierte Oberfläche mit einem funktionellen Haftsilan zu behandeln (Silanisierung). Bei diesem Stand der Technik wird folglich mittels der Flammsilikatisierung zunächst eine Zwischenschicht zur verbesserten Haftung von chemischen Haftvermittlern auf Silanbasis geschaffen. Auf den Einsatz eines solchen zusätzlichen Haftvermittlers wird im Rahmen der Erfindung verzichtet.

In der DE 10 2007 004 229 A1 wird die Flammsilikatisierung im Zusammenhang mit dem Bedrucken von Kunststoff beschrieben. Es erfolgt eine Behandlung der Oberfläche durch Beflammung bzw. Silikatisierung, vorzugsweise Flammpyrolyse von Silanen. Anschließend erfolgt jedoch zwingend eine Beaufschlagung des Substrats mit einer Primerung und erst dann wird eine Funktionsschicht auf das mit der Primerung beaufschlagte Substrat aufgebracht, wobei die Funktionsschicht nachträglich mit einer Dekorbeschichtung beaufschlagbar ist.

Die DE 10 2006 045 951 A1 offenbart ein Verfahren zur chemischen Modifizierung und/oder Aktivierung von Kunststoffoberflächen, wobei unter Zusatz von siliziumorganischen Verbindungen oder Silanen die Oberfläche mit einer Flamme behandelt wird. Die Flammsilikatisierung wird in der Praxis im Übrigen in der Zahnmedizin eingesetzt. Auch dort handelt es sich in der Regel um einen zweistufigen Prozess, um verschiedene Materialien miteinander zu verbinden oder um Metalloberflächen mit keramischen Bestandteilen zu beschichten. Es wird zunächst ein Haftgrund durch Silikatisieren erzeugt und darauf durch Silanisierung ein Haftvermittler verankert, so dass anschließend eine feste Verbindung der zahntechnischen Materialien möglich wird.
Auf das haftvermittlerfreie Verkleben von Kunststoffleisten, insbesondere Kantenbändern für die Schmalflächenbeschichtung von Möbelplatten, hatten all diese Entwicklungen keinen Einfluss.

Die Erfindung geht folglich von der überraschenden Erkenntnis aus, dass eine haftvermittlerfreie Verklebung von Kunststoffleisten und insbesondere Kantenbändern möglich ist, wenn die zu verklebende Fügefläche mittels Flammsilikatisierung unter Bildung einer Siliziumdioxidbeschichtung (ohne vorherigen oder anschließenden Haftvermittlerauftrag) vorbehandelt wird. Die Kantenleiste lässt sich folglich kostengünstig herstellen, da auf Haftvermittler verzichtet wird. Außerdem erfolgt eine einfache Verarbeitung ohne den Einsatz von Haftvermittler und dennoch wird eine einwandfreie Verbindung der Leiste mit dem Werkstück erreicht. Alternativ erlaubt diese Oberflächenbeschichtung auch Farben, Lacke und Heißsiegelfolien ohne den Einsatz von zusätzlichen Haftvermittlern praxisgerecht aufzubringen. Ein besonderer Vorteil der erfindungsgemäß verklebten, bedruckten oder lackierten Kunststoffleisten oder Kunststoffteile ist ihre gegenüber dem Stand der Technik deutlich verbesserte Wärmealterungs- und Feuchtebeständigkeit.

Die durch Flammsilikatisierung erzeugte SiO₂-Beschichtung weist vorzugsweise eine Schichtdicke von 10 nm bis 500 nm, vorzugsweise 20 nm bis 300 nm, auf. Durch Versuche lässt sich eine optimale Schichtdicke ermitteln, die in dem angegebenen Bereich liegt.
Bei der Kunststoffleiste kann es sich um eine Leiste aus einem herkömmlichen Kunststoff handeln, insbesondere aus der Familie der Polyolefine (z. B. PP, PE), der technischen Thermoplaste (z. B. ABS, PMMA, PC). Alternativ kommen auch andere bekannte Werkstoffe, wie z. B. PVC, PS, TPO-E, PA, SEBS, TPU usw. zum Einsatz. Solche Kunststoffleisten können im Wege der Extrusion aus einem einzigen Kunststoff hergestellt werden. Es liegt jedoch ebenso im Rahmen der Erfindung, Kunststoffleisten zu verwenden, die aus mehreren coextrudierten Polymeren bestehen, z. B. mehrschichtige Kunststoffleisten. Die Kunststoffleiste ist in der Regel in einer für technische Produkte üblichen Modifizierung mit Füllstoffen (z. B. mineralischen Füllstoffen, z. B. Kreide, Talkum etc.) versehen. Ferner können Verarbeitungshilfen (z. B. Thermostabilisatoren, Oxidationsschutzmittel, Lichtstabilisatoren, Verträglichkeitsvermittler, Gleitmittel usw.) zum Einsatz kommen. Außerdem können Farben (z. B. organische und/oder anorganische Pigmente und Farbstoffe) sowie Weichmacher usw. vorliegen.

Gegenstand dieser Offenbarung ist nicht nur die oben beschriebene Kunststoffleiste, sondern auch ein Verfahren zum Herstellen einer solchen Kunststoffleiste. Dieses Verfahren ist dadurch gekennzeichnet, dass die zu verklebende Fügefläche mittels Flammsilikatisierung vorbehandelt wird. Für die Flammsilikatisierung wird die Fügefläche mit einer Flamme beaufschlagt, indem ein Brenngas verbrannt wird, wobei dem Brenngas eine oder mehrere Silane oder Silanverbindungen zugesetzt werden. Als Brenngas kommt in der Regel ein Gas-/Luftgemisch zum Einsatz, wobei es sich bei dem Gas um Kohlenwasserstoff, z. B. Methan, Erdgas, Propan, Butan oder Gemische aus diesen Gasen handeln kann, die in verschiedenen stechiometrischen Verhältnissen mit Luft gemischt werden. Dabei werden geeignete siliziumorganische Verbindungen (Silane) dem Brennergasgemisch (Luft/Gas) zugesetzt, und zwar bevorzugt in einer Konzentration von 0,5 Vol.-% bis 3 Vol.-%, und zwar bezogen auf das Luftstromvolumen. Bei den Silanen kann es sich z. B. um HMDSO, HMDSN (Hexamethyldisilazan) oder um TOS handeln.

Mit der erfindungsgemäßen Flammsilikatisierung sind zwei Prozesse verbunden. Im Rahmen eines ersten Prozesses erfolgt eine Flammvorbehandlung zur Aktivierung der Kunststoff-Oberflächen von z. B. PE, PP durch Oxidation der Oberflächen und der damit verbundenen Erzeugung von reaktiven Gruppen bzw. der Einbindung von Sauerstoff an der Oberfläche des Polymers. Dieser Prozess wird in der Regel im oxidativen Bereich des Flammkegels erreicht und führt zur Erhöhung der Oberflächenspannung und Polarität. Bei der Flammvorbehandlung können verschiedene Gase (Kohlenwasserstoffe), z. B. Methan, Erdgas, Propan, Butan oder Gemische aus diesen in verschiedenen stechiometrischen Verhältnissen mit Luft gemischt, mittels einer Brennerdüse verbrannt werden.

Im Rahmen des zweiten Prozesses erfolgt die Silikatisierung (Flammpyrolyse) und folglich die Beschichtung der durch die Flamme aktivierten Kunststoffoberfläche mit polymerem amorphen SiO₂-n-Strukturen durch Oxidation bzw. Polymerisation von Silanen, das heißt von siliziumorganischen Verbindungen wie z. B. HMDSO, HMDSN oder TOS, in der Flamme, wobei eine Anhaftung der SiO₂-n-Struktur mit der Polymeroberfläche erzeugt wird.

Zu diesem Zweck wird die entsprechende Silanverbindung (Precursor) in einer Konzentration von z. B. 0,1 % bis 3 % dem Luft-/Gasgemisch zugesetzt. Die Dosierung des Silans bezieht sich auf die Litermenge Luft/Minute im Brenngasgemisch.

Die Schichtstärke und/oder die Partikelgröße der SiO₂-n-Beschichtung kann durch die Silankonzentration, dem Luft-/Gasgemisch-Durchsatz sowie die Einwirkzeit der Flammsilikatisierung auf der Kunststoffoberfläche variiert werden. In der Regel liegen die aufgebrachten Schichtdicken und/oder Partikelgrößen im Bereich von 20 nm bis 400 nm. Der Prozess wird so geführt, dass eine optimale Beschichtung mit dem Ziel erreicht wird, die Kunststoffoberfläche anschließend haftvermittlerfrei zu verkleben. Dabei ist zu beachten, dass mit steigender Schichtdicke der SiO₂-n-Beschichtung das hydrophobe Verhalten der gebildeten Beschichtung zunimmt, was zur Folge hat, dass die Benetzung von Wasser bzw. die Oberflächenspannung deutlich abnimmt. Eine Benetzung und Haftung auf dieser Oberfläche wird dann immer schwerer, so dass mit begrenzten Schichtdicken gearbeitet wird.

Das Gas/Luft-Mischungsverhältnis kann bei verschiedenen Gasen variiert werden. Sofern Erdgas mit Luft gemischt wird, kommt z. B. ein Mischungsverhältnis Erdgas : Luft von 1 : 7,4 bis 10 in Frage. Für Methan und Luft kommt z. B. ein Verhältnis Methan : Luft von 1 : 7 bis 11 in Frage. Im Falle von Propan kommt z. B. ein Mischungsverhältnis Propan : Luft von 1 : 16 bis 22 in Frage. Bei Gasgemischen aus Methan/Propan/Butan und Luft hat sich z. B. ein Mischungsverhältnis von z. B. 1 : 20 bewährt.

Für die Erzeugung der Flamme können übliche Brennerdüsen verwendet werden. Bevorzugt werden mehrreihige Brennerdüsen eingesetzt, die z. B. mit zwei- bis fünfreihigen Lochdüsen versehen sind.

Der Brennerdüsenabstand bei der Flammsilikatisierung zu dem zu behandelnden Band/Profil beträgt in der Regel 10 mm bis 150 mm, vorzugsweise 20 mm bis 100 mm.

Die Vorbehandlung im Sinne einer Flammsilikatisierung kann z. B. bei einer Kunststoffleiste oder einem Kantenband kontinuierlich bei fortlaufender Kunststoffleiste erfolgen. Die Bahngeschwindigkeiten der transportierten Kunststoffleiste kann z. B. 5 m/min bis 50 m/min, vorzugsweise 10 m/min bis 35 m/min betragen.

Die Kunststoffleiste, z. B. das Kantenband, wird z. B. im Wege der Kunststoff-Extrusion hergestellt. In diesem Fall besteht die Möglichkeit, die Vorbehandlung durch Flammsilikatisierung "inline" bei der Extrusion bzw. im unmittelbaren Anschluss an die Extrusion durchzuführen. Alternativ liegt es jedoch auch im Rahmen der Erfindung die Vorbehandlung zu einem späteren Zeitpunkt "offline" durchzuführen.

Die Flammsilikatisierung kann einseitig, doppelseitig oder umlaufend durchgeführt werden. Außerdem liegt es im Rahmen der Erfindung, dass der Precursormenge (Silankonzentration) bei der Flammsilikatisierung (Flammpyrolyse) zur Erzeugung von unterschiedlichen Oberflächeneigenschaften in Teilbereichen (z. B. hydrophil / dispers / hydrophob) weg- oder zeitgesteuert wird.

Bevorzugt wird lediglich die zu verklebende Fläche mit Flammsilikatisierung vorbehandelt. Bei einem Kantenband kann es sich um die zu fügende Rückseite handeln. Es liegt jedoch ebenfalls im Rahmen der Erfindung, sowohl die Rückseite als auch die Frontseite und folglich die Sichtseite mit Flammsilikatisierung zu behandeln. Dabei liegt es im Rahmen der Erfindung, die Oberseite einerseits und die Unterseite andererseits mit unterschiedlichen Flammsilikatisierungseinstellungen zu behandeln.

Schließlich ist Gegenstand der Erfindung ein Verfahren gemäß Anspruch 1 zum Befestigen einer Kunststoffleiste an einem Werkstück, insbesondere an eine Schmalfläche einer Möbelplatte oder dergleichen. Dieses Verfahren ist dadurch gekennzeichnet, dass die Leiste unter Verzicht auf einen Haftvermittler mit einem Klebstoff mit dem Werkstück verklebt wird. Bevorzugt handelt es sich bei dem Klebstoff um einen Schmelzklebstoff und folglich einen Hotmelt. Dabei können übliche Schmelzklebstoffe auf Basis von EVA, APAO, TPU, TPE, PA, PUR zum Einsatz kommen. Das erfindungsgemäße Verfahren zeichnet sich dadurch aus, dass eine Verklebung der haftvermittlerfreien Kunststoffleiste ohne den Einsatz von Haftvermittler möglich ist.
Bevorzugt werden im Rahmen der Erfindung Kantenbänder mit Möbelplatten verklebt. Die Erfindung umfasst aber auch die Verarbeitung anderer Kunststoffleisten und anderer Kunststoffprofile.
Das erfindungsgemäße Verfahren wurde durch entsprechende Versuche verifiziert. Es wurde ein Parameterfeld ermittelt, bei dem die gebildete SiO₂-Beschichtung eines PP-Bandes eine mittlere Schichtdicke von 180 nm und eine Oberflächenspannung von 70 bis 72 dyn (Testtinte) erreicht. Entsprechende positive Verklebungsprüfung mit unterschiedlichen polaren Schmelzklebstoffen (EVA-, APAO-, PUR-Systemen) zeigen, dass die Oberflächenausbildung der Kunststoffbänder und Profile über ein ausgewogenes hydrophiles/hydrophobes Gleichgewicht verfügt. Dabei stellte sich überraschend heraus, dass die Beständigkeit gegen Alterung, Wärmealterung, Feuchtelagerung usw. der so hergestellten Bänder und Profile sowohl im nicht verklebten Zustand als auch im verklebten Zustand deutlich besser waren als entsprechende Vergleichsmuster nach dem Stand der Technik, die in herkömmlicher Weise mit Haftvermittler beschichtet waren. Diese verbesserte Beständigkeit der Oberflächenaktivierung von Kunststoffen gestattete es, entsprechende Bänder/Profile auch zu einem wesentlich späteren Zeitpunkt zu verkleben bzw. nachzulackieren. Die Beständigkeit der Vorbehandlungsgüte über einen langen Zeitraum zeichnet diese Profile folglich gegenüber dem Stand der Technik ebenfalls aus.

### Folgendes Ausführungsbeispiel wird angegeben:

Bei der Extrusion eines Bandes/Profils aus PP, bestehend aus 75 Teilen PP, 15 Teilen Füllstoff (mineralisch), 2 Teilen Kopplungsadditiv (zur verbesserten Anbindung Füllstoff - Polymer), 3 Teilen Verarbeitungshilfen (Gleitmittel, Antioxydantien etc.) und 5 Teilen Pigmentpräperation (Pigmente, Farbstoffe, Lichtschutzmittel) mit einer Bahngeschwindigkeit von 15 m/min wird das ausgeformte und abgekühlte Band/Profil beidseitig (das heißt Oberseite und Unterseite) mittels fünfreihiger Gasbrennerdüsen (oben und unten) in einem Brennerabstand von 20 mm zur Band bzw. Profiloberfläche über die gesamte Band bzw. Profilbreite quer zur Extrusionsrichtung flammsilikatisiert und folglich oberflächenbehandelt. Dabei besteht das Brennergasgemisch aus einer Erdgas/ Luftabschmischung im Verhältnis 1 : 8. Dem zündfähigen Brennergasgemisch sind 0,5 % Silan HMDSN (Hexamethyldisilazan) bezogen auf die Luftmenge im Brennergas zugemischt. Die Gasflamme ist bei dem Düsenabstand von 20 mm zur Band-/Profiloberfläche so eingestellt, dass der oxidierende Flammbereich auf die Kunststoffoberfläche trifft. Die so vorbehandelte und folglich silikatbeschichtete Oberfläche weist eine Oberflächenspannung von 70 bis 72 dyn (mit Testtinte) auf. Die Oberseite der Leiste kann im Durchlauf wahlweise mit üblichen Farben oder Lacken (Lösemittel-, wässrige oder UV-Systeme) bedruckt und/oder lackiert werden. Die Haftung der Farb-, Lackbeschichtung weist eine sehr gute Haftung auf. Das Band oder Profil kann sofort oder später auf z. B. einer Holzwerkstoffplatte praxisgerecht verklebt werden, bevorzugt mit einem Hotmelt oder einem anderen Klebstoff.

## Patentansprüche

1. Verfahren zum Befestigen einer Kunststoffleiste an einer Schmalfläche eines plattenförmigen Werkstücks,
wobei die Kunststoffleiste eine zu verklebende Fügefläche aufweist, die mittels Flammsilikatisierung unter Bildung einer SiO₂-Beschichtung vorbehandelt ist, wobei die Kunststoffleiste unter Verzicht auf einen Haftvermittler mit einem Klebstoff mit dem Werkstück verklebt wird.

2. Verfahren nach Anspruch 1, **dadurch gekennzeichnet, dass** die durch Flammsilikatisierung erzeugte SiO₂-Beschichtung eine Schichtdicke von 10 nm bis 500 nm, vorzugsweise 20 nm bis 300 nm aufweist.

3. Verfahren nach Anspruch 1 oder 2, **dadurch gekennzeichnet, dass** die Kunststoffleiste aus zumindest einem thermoplastischen Kunststoff, z. B. einem Polyolefin (z. B. PP, PE), ABS, PMMA, PC, PVC oder PS gefertigt ist.

4. Verfahren nach einem der Ansprüche 1 bis 3, **dadurch gekennzeichnet, dass** die Kunststoffleiste mit einem Schmelzklebstoff (Hotmelt) mit dem Werkstück verklebt wird.

5. Verfahren nach Anspruch 4, **dadurch gekennzeichnet, dass** die Kunststoffleiste mit einem Schmelzklebstoff auf Basis von EVA, APAO, TPU, TPE, PA und oder PUR verklebt wird.

6. Verfahren nach einem der Ansprüche 1 bis 5, **dadurch gekennzeichnet, dass** für die Flammsilikatisierung die Fügefläche mit einer Flamme beaufschlagt wird, indem ein Brenngas verbrannt wird, wobei dem Brenngas ein oder mehrere Silane bzw. Silanverbindungen zugesetzt werden.

7. Verfahren nach Anspruch 6, **dadurch gekennzeichnet, dass** die Silane bzw. deren Verbindungen in einer Konzentration von 0,1 Vol.-% bis 5 Vol.-%, vorzugsweise 0,1 Vol.-% bis 3 Vol.-% dem Brenngas zugesetzt werden.

8. Verfahren nach Anspruch 6 oder 7, **dadurch gekennzeichnet, dass** als Brenngas ein Gas-Luft-Gemisch verwendet wird, welches als Gas ein Kohlenwasserstoff-Gas enthält, z. B. Erdgas, Methan, Propan oder Butan oder ein Gemisch aus diesen Gasen.

9. Verfahren nach einem der Ansprüche 6 bis 8, **dadurch gekennzeichnet, dass** der Abstand der für die Erzeugung der Flamme verwendeten Brennerdüse von der vorzubehandelnden Fügefläche 10 mm bis 100 mm, z. B. 20 mm bis 100 mm, beträgt.

10. Verfahren nach einem der Ansprüche 1 bis 9, **dadurch gekennzeichnet, dass** eine Kunststoffleiste in einem kontinuierlichen Durchlauf mit einer Behandlungsgeschwindigkeit von 5 m/min bis 50 m/min, z. B. 10 m/min bis 35 m/min vorbehandelt wird.

11. Verfahren nach einem der Ansprüche 1 bis 10, **dadurch gekennzeichnet, dass** eine durch Extrusion hergestellte Kunststoffleiste inline während der Extrusion oder im Anschluss an die Extrusion vorbehandelt wird.

12. Verfahren nach einem der Ansprüche 1 bis 11, **dadurch gekennzeichnet, dass** zusätzlich zu der zu verklebenden Fügefläche eine zu bedruckende oder zu lackierende Sichtfläche vorbehandelt wird.

13. Verfahren nach einem der Ansprüche 1 bis 12, **dadurch gekennzeichnet, dass** die Menge/Konzentration des der Flamme zugegebenen Silans bei der Flammsilikatisierung zur Erzeugung von unterschiedlichen Oberflächeneigenschaften in Teilbereichen weg- oder zeitgesteuert wird.

## Claims

1. A method for attaching a plastic strip to a narrow surface of a plate-shaped workpiece,
wherein the plastic strip comprises a joint surface to be adhered which is pre-treated by means of flame silication forming a SiO₂ coating, wherein the plastic strip is adhered to the workpiece eschewing a bonding agent with an adhesive.

2. The method according to claim 1, **characterised in that** the SiO₂ coating produced by flame silication has a layer thickness of 10 nm to 500 nm, preferably 20 nm to 300 nm.

3. The method according to claim 1 or 2, **characterised in that** the plastic strip is made of at least one thermoplastic synthetic material, e.g. a polyolefin (e.g. PP, PE), ABS, PMMA, PC, PVC or PS.

4. The method according to any one of claims 1 to 3, **characterised in that** the plastic strip is adhered to the workpiece with a hotmelt.

5. The method according to claim 4, **characterised in that** the plastic strip is adhered with an EVA, APAO, TPU, TPE, PA and/or PUR-based hotmelt.

6. The method according to any one of claims 1 to 5, **characterised in that** for the flame silication a flame acts on the joint surface **in that** a combustion gas is burned, wherein one or more silanes or silane compounds are added to the combustion gas.

7. The method according to claim 6, **characterised in that** the silanes and/or their compounds are added to the combustion gas in a concentration of 0.1 % by volume to 5% by volume, preferably 0.1% by volume to 3% by volume.

8. The method according to claim 6 or 7, **characterised in that** as the combustion gas a gas-air mixture is used, which as the gas contains a hydrocarbon gas, e.g. natural gas, methane, propane or butane or a mixture of these gases.

9. The method according to any one of claims 6 to 8, **characterised in that** the distance of the burner nozzle used for producing the flame from the joint surface to be pre-treated is 10 mm to 100 mm, e.g. 20 mm to 100 mm.

10. The method according to any one of claims 1 to 9, **characterised in that** the plastic strip is pre-treated in a continuous pass with a treatment speed of 5 m/min to 50 m/min, e.g. 10 m/min to 35 m/min.

11. The method according to any one of claims 1 to 10, **characterised in that** a plastic strip produced by extrusion is pre-treated inline during the extrusion or subsequent to extrusion.

12. The method according to any one of claims 1 to 11, **characterised in that** in addition to the joint surface to be adhered, a visible surface to be printed or varnished is pre-treated.

13. The method according to any one of claims 1 to 12, **characterised in that** the quantity/concentration of the silane added to the flame during flame silication is path or time-controlled in order to produce different surface qualities in sections.

## Revendications

1. Procédé, destiné à fixer une bande de matière plastique sur une surface étroite d'une pièce à usiner en forme de panneau,
la bande de matière plastique comportant une surface de jointage à coller, qui est prétraitée au moyen d'un flammage avec silicatisation sous création d'un revêtement de SiO₂, la bande de matière plastique étant collée à l'aide d'un agent adhésif sur la pièce à usiner, en renonçant à un agent de pontage.

2. Procédé selon la revendication 1, **caractérisé en ce que** le revêtement de SiO₂ créé par flammage avec silicatisation présente une épaisseur de couche de 10 nm à 500 nm, de préférence de 20 nm à 300 nm.

3. Procédé selon la revendication 1 ou 2, **caractérisé en ce que** la bande de matière plastique est fabriquée en au moins une matière thermoplastique, par exemple en une polyoléfine (par exemple en. PP, PE), en ABS, PMMA, PC, PVC ou en PS.

4. Procédé selon l'une quelconque des revendications 1 à 3, **caractérisé en ce que** la bande en matière plastique est collée sur la pièce à usiner avec un agent adhésif thermofusible.

5. Procédé selon la revendication 4, **caractérisé en ce que** la bande de matière plastique est collée avec un agent adhésif thermofusible sur base d'EVA, d'APAO, de TPU, de TPE, de PA et/ou de PUR.

6. Procédé selon l'une quelconque des revendications 1 à 5, **caractérisé en ce que** pour le flammage avec silicatisation, on expose la surface d'assemblage à une flamme, **en ce qu'**on fait brûler un gaz combustible, sachant qu'on ajoute au gaz combustible un ou plusieurs silanes ou composés de silane.

7. Procédé selon la revendication 6, **caractérisé en ce que** les silanes ou leurs composés sont ajoutés au gaz combustible dans une concentration de 0,1 % en volume à 5 % en volume, de préférence de 0,1 % en volume à 3 % en volume.

8. Procédé selon la revendication 6 ou 7, **caractérisé en ce qu'**on utilise en tant que gaz combustible un mélange gaz/air qui contient en tant que gaz un gaz d'hydrocarbure, par ex. du gaz naturel, du méthane, du propane ou du butane ou un mélange desdits gaz.

9. Procédé selon l'une quelconque des revendications 6 à 8, **caractérisé en ce que** l'écart entre les buses de brûleur utilisées pour créer la flamme et la surface de jointage prétraitée est de 10 mm à 100 mm, par exemple de 20 mm à 100 mm.

10. Procédé selon l'une quelconque des revendications 1 à 9, **caractérisé en ce qu'**on prétraite une bande de matière plastique en un passage continu à une vitesse de traitement de 5 m/mn à 50 m/mn, par exemple de 10 m/mn à 35 m/mn.

11. Procédé selon l'une quelconque des revendications 1 à 10, **caractérisé en ce qu'**on prétraite dans la ligne pendant l'extrusion ou à la suite de l'extrusion une bande de matière plastique fabriquée par extrusion.

12. Procédé selon l'une quelconque des revendications 1 à 11, **caractérisé en ce qu'**en supplément de la surface de jointage qui doit être collée, on prétraite une surface de couche qui sera imprimée ou peinte.

13. Procédé selon l'une quelconque des revendications 1 à 12, **caractérisé en ce que** pour créer différentes propriétés de surface dans des zones partielles, la quantité/concentration du silane ajoutée à la flamme lors du flammage avec silicatisation est initiée par commande proportionnelle au temps ou à la course,
